# EUROPEAN PATENT APPLICATION

(11) **EP 1 020 487 A1**
(43) Date of publication of application: **19.07.2000**
(21) Application number: 98944251.2
(22) Date of filing: 28.09.1998
(51) Int. Cl.: C08J 3/20, C08J 5/18, B32B 18/00, B32B 27/20

(54) **PLASTIC-CERAMIC COMPOSITE MATERIAL**

(30) Priority: 30.09.1997 JP 26582397; 30.09.1997 JP 26582497; 30.09.1997 JP 26582597
(71) Applicant: NGK INSULATORS, LTD., Nagoya-City, Aichi Prefecture 467-8530 (JP)
(72) Inventor: OTAGIRI, Tadashi, Aichi-prefecture 457-0037 (JP); SUZUKI, Tomio, Mie-prefecture 512-8027 (JP)
(74) Representative: Leson, Thomas Johannes Alois, Dipl.-Ing.
(86) International application number: JP9804321
(87) International publication number: WO9916813

(57) **Abstract**

A plastic-ceramic composite includes: a plastic matrix, and ceramic particles dispersed in said plastic matrix. The ceramic has a property selected from a group consisting of dielectricity, piezoelectricity, magnetism, conductivity, and heat conductivity. Alternatively, there is used at least two kinds of ceramics corresponding to at least two properties. A content of the ceramic particles is 50 vol% or more and 99 vol% or less. The plastic has at least one property selected from a group consisting of dielectricity, piezoelectricity, and magnetism; The ceramic has at least one property selected from a group consisting of dielectricity, piezoelectricity, magnetism, conductivity, and heat conductivity; and a content of the ceramic particles is 30 vol% or more and 99 vol% or less. It can be easily produced at a low cost by an injection molding, and improvement of productivity can be intended. The composite having complex shape which cannot be formed by machining can be easily molded. The composite has a property of ceramic and at least two kinds of different properties. A characteristic value of the composite can be controlled freely.

## Description

### Technical Field

The present invention relates to a plastic-ceramic composite having dielectricity, piezoelectricity, magnetism or the like and being used for various electric/electronic parts and the like.

### Background Art

Functional ceramics and plastics having dielectricity, piezoelectricity, magnetism or the like, have been used for various electric/electronic parts in a wide range of fields. For example, silica glass, alumina, aluminum nitride, etc., are known as ceramics having low dielectricity; and titania, barium titanate, etc., are known as ceramics having high dielectricity. These ceramics are used for IC packages, condensers, LC filters and the like. Ceramics having piezoelectricity, lead zirconate titanate, etc., are used for various actuators, vibrating gyroscopes, sensors, resonators and the like.

However, molding a ceramic to give it a desired shape requires a firing step, and then additionally usually must be subjected to machining after firing. Therefore, molding of ceramics is expensive and has more complicated steps in comparison with molding of plastic. Further, since it is difficult to mold an article having a complex shape, there is a low degree of flexibility in molding. Further, controlling properties which a ceramic material possesses such as dielectricity is difficult.

On the other hand, plastic is characterized as having excellent moldability and can be produced with high precision at a low cost, even with a complex shape.

Considering the aforementioned properties, it would be useful if two or more materials with different properties could be used to impart a plurality of properties derived from a plurality of materials to a single member. For example, a ceramic material having piezoelectricity is used in combination with a ceramic material having high heat conductivity, which enables a high-speed actuator or the like, to radiate heat generated in accordance with vibrations of a couple of piezoelectric bodies.

However, it is difficult to impart a plurality of properties derived from a plurality of ceramics to a member by simply mixing at least two kinds of ceramic particles having different properties because ceramics react differently during firing. Additionally, it is generally difficult to manipulate freely a property such as dielectricity of a ceramic to fit its use.

The present invention has been made in consideration of such conditions, and the object of the present invention is to provide a composite which has properties close to those of a functional ceramic with regard to dielectricity, piezoelectricity, magnetism or the like, and which can be easily molded to have any shape at a low cost.

Another object of the present invention is to provide a composite which has at least two different properties which can be independently manipulated freely.

### Disclosure of Invention

According to the present invention, there is provided a plastic-ceramic composite (first invention) comprising:
a plastic matrix, and
ceramic particles dispersed in the plastic matrix;
   wherein the ceramic has a function selected from a group consisting of dielectricity, piezoelectricity, magnetism, conductivity and heat conductivity, and a content of the ceramic particles is 50 vol% or more and 99 vol% or less.

The ceramic particles may comprise at least two kinds of ceramics having different characteristic values and the same property.

According to the present invention, there is further provided a plastic-ceramic composite (second invention) comprising:
a plastic matrix, and
ceramic particles dispersed in the plastic matrix;
   wherein, as the ceramic, at least two different ceramics corresponding with at least two properties selected from a group consisting of dielectricity, piezoelectricity, magnetism, conductivity and heat conductivity are employed; and the content of the ceramic particles is 50 vol% or more and 99 vol% or less.

The plastic-ceramic composite may have a laminated structure having layers, each of which contains ceramic different from that of the other layer(s).

Each of the layers may contain at least two kinds of ceramics corresponding with the at least two properties in a compounding ratio different from that of the other layer(s).

The plastic-ceramic composite may comprises a layer containing at least two ceramics corresponding with the at least two properties.

According to the present invention, there is furthermore provided a plastic-ceramic composite (third invention) comprising:
a plastic matrix, and
ceramic particles dispersed in the plastic matrix;
   wherein the plastic has at least one property selected from a group consisting of dielectricity, piezoelectricity and magnetism; the ceramic has at least one property selected from a group consisting of dielectricity, piezoelectricity, magnetism, conductivity and heat conductivity; and the content of the ceramic particles is 30 vol% or more and 99 vol% or less.

Each of the ceramic particles preferably has an aspect ratio of 2.0 or less.

The ceramic particles are preferably combined with a plastic matrix by silane-coupling.

According to the present invention, there is furthermore provided an article obtained by subjecting one of the aforementioned plastic-ceramic composites to injection molding. According to the present invention, there is furthermore provided an article obtained by molding one of the aforementioned plastic-ceramic composites into the shape of a sheet.

### Brief Description of Drawings

Fig. 1 is a schematic sectional view showing an example of a plastic-ceramic composite of the second invention.
Fig. 2 is a schematic sectional view showing another example of a plastic-ceramic composite of the second invention.
Fig. 3 is a schematic sectional view showing still another example of a plastic-ceramic composite of the second invention.

### Best Mode for Carrying Out the Invention

The present invention is hereinbelow described in detail.

As described above, the present invention includes the first and the third inventions and is described in order from the first invention.

In a ceramic-plastic composite of the first invention, ceramic particles are dispersed in a plastic matrix. There is employed a ceramic having a property selected from a group of dielectricity, piezoelectricity, magnetism, conductivity and heat conductivity. The content of the ceramic particles is 50 vol% or more and 99 vol% or less.

Since the plastic-ceramic composite of the first invention is produced by dispersing ceramic particles in a plastic material, it can be easily produced at a low cost by injection molding or the like. That is, since it does not need firing or machining after firing, improvement in productivity can be expected. Further, it can be easily molded into complex shapes which are not possible to make through machining.

By controlling the content of ceramic particles to be 50 vol% or more, properties of the ceramic particles can be effectively imparted to the composite to be obtained. Incidentally, the content of ceramic particles is preferably 70 vol% or more, more preferably 80 vol% or more. On the other hand, the content of ceramic particles is controlled to be 99 vol% or less because molding is impossible when the content of ceramic particles exceeds 99 vol% because the content of plastic is too small to maintain flowability of a composite.

In the composite of the first invention, it is possible to control characteristic values to accord with their intended use by changing the content of ceramic particles with properties such as dielectricity, piezoelectricity, and magnetism or by changing the compounding ratio of at least two kinds of ceramic particles which have different characteristic values and the same properties. Particularly, regarding dielectricity, an intermediate dielectric constant can be obtained in accordance with a compounding ratio because of the additivity in mixing ceramic particles having different dielectric constants. Control of the temperature coefficient is also possible in the same manner. Incidentally, dielectricity includes insulation performance.

Regarding piezoelectricity, not only controlling piezoelectricity but also a temperature coefficient of frequency can be controlled by mixing ceramic particles having different piezoelectric constants. This enables, for example, a vibrating gyroscope and a resonator each having a temperature coefficient of about 0.

A plastic material used for a plastic-ceramic composite of the first invention may be composed of either of a thermosetting resin or a thermoplastic resin. However, a thermoplastic resin is preferable because it can be easily molded in injection molding.

As a thermoplastic resin, there can be used a resin such as hard vinyl chloride, polyethylene, polypropylene, polyethylene terephthalate, polyacrylate, polystyrene, ABS resin, polyacetal, nylon 6, nylon 66, poly( ethylene tetrafluoride), polycarbonate, poly(vinylidene fluoride), polyetherimide, reinforced poly( ethylene terephthalate), poly( phenylene sulfide), poly amide-imide, poly(ether-ether-ketone), polyimide and various kinds of liquid crystal plastics. More than one of the resins from the above may be used in combination. Among the aforementioned thermoplastic resins, there is preferably used for a plastic-ceramic composite a resin having high thermal resistance, i.e., a resin having a heat distortion temperature of 100°C or more (HDT in a condition of 4.6kg/cm²), such as polyacrylate, polystyrene, ABS resin, polyacetal, nylon 6, nylon 66, poly(ethylene tetrafluoride), polycarbonate, poly(vinyliden fluoride), poly(ether-imide), reinforced poly(ethylene terephtalate), poly(phenylene sulfide), poly amide-imide, poly(ether-ether-ketone) or polyimide. There is more preferably used a resin having a heat distortion temperature of 150°C or more, such as nylon 6, nylon 66, poly(vinylidene fluoride), polyetherimide, reinforced poly(ethylene terephthalate), poly(phenylene sulfide), poly amide-imide, poly(ether-ether-ketone) or polyimide.

On the other hand, as a thermosetting resin, there may be used phenol resin, epoxy resin, unsaturated polyester, urea resin, melamine resin, urethane resin, silicon resin or the like. Two or more of the aforementioned thermosetting resins may be used in combination.

As a ceramic having dielectricity to be used for a plastic-ceramic composite of the first invention, there may be used titanium oxide, magnesium titanate, calcium titanate, strontium titanate, barium titanate, lead titanate, lead zirconate, niobate, tantalate, gallate, alumina, mullite, steatite, silica glass or the like.

As a ceramic having piezoelectricity, there may be used barium titanate, solid solution of PbZrO₃-PbTiO₃(PZT), solid solution of PbZrO₃-PbTiO₃-Pb(Mg_{1/3}Nb_{2/3})O₃(PZT-PMN) or the like.

As a ceramic having magnetism, there may be used various kinds of ferrites such as Mn-Zn ferrite and Ni-Zn ferrite.

As a ceramic having conductivity, there may be used a boride such as ZrB₂ and TiB₂, a carbide such as C, TiC and SiC, nitride such as TiN, and an oxide such as SnO₂, TiO₂, CrO₂, RuO₂, ReO₂, WO₂, SrFeO₃, SrTiO₃ or In₂O₃.

As a ceramic having high heat conductivity, there may be used beryllia, alumina, diamond, silicon carbide, silicon nitride, aluminum nitride or the like.

In a plastic-ceramic compound of the first invention, each of the ceramic powders has an aspect ratio of 2.0 or less.

By controlling the aspect ratio within the aforementioned range, ceramic particles can be dispersed beyond the closest packing, thereby decreasing the coefficient of thermal expansion of the composite. That is, when the aspect ratio of a ceramic particle exceeds 2.0, it is difficult to increase the content of ceramic particles.

The ceramic particles preferably have an average particle diameter of 0.1 - 50 µm. This is because, when the average particle diameter is lower than 0.1 µm or exceeds 50 µm, flowability upon molding is lost, and improvement in productivity becomes unobtainable.

Next, the second invention is described. When a portion of the constitution in the second invention is the same as that of the first invention, its description is omitted.

In a plastic-ceramic composite of the second invention, ceramic particles are dispersed in a plastic matrix. As a material for the ceramic particles, there are used at least two kinds of ceramic materials corresponding with at least two properties selected from the group of dielectricity, piezoelectricity, magnetism, conductivity, and heat-conductivity. The content of ceramic particles is 50 vol% or more and 99 vol% or less.

A plastic-ceramic composite of the second invention has at least two properties derived from at least two kinds of ceramic materials. Thus, a plurality of members each having its own properties can be replaced by a single member, the composite of the second invention, which can contribute to improvement in productivity, cost decreases, and decreases in the number of members. Alternatively, a completely new use can be found. For example, in a high-speed high-displacement actuator or the like when a ceramic having piezoelectricity is used together with a ceramic having high heat-conductivity, heat generated due to vibrations of the piezoelectric body can be diffused and the temperature related property changes can be reduced.

Since a plastic-ceramic composite of the second invention can be obtained by dispersing ceramic particles in a plastic, such a composite can be easily produced by an injection molding or the like, at a low cost. Therefore, although at least two kinds of ceramic particles having different properties are used, each kind of ceramic does not lose properties when different kinds of ceramics react with one another. Thus, properties derived from at least two kinds of different ceramics can be imparted to a composite.

Regarding dielectricity, piezoelectricity, magnetism and the like, of a composite of the second invention, the characteristic value of a composite derived from each ceramic can be independently controlled to accord with its intended use by changing the content or the compounding ratio of ceramic particles.

A composite of the second invention may include at least two kinds of ceramics having the same kinds of properties. In this case, the characteristic value of a composite can be controlled by changing the compounding ratio of the ceramic if the ceramics have different characteristic values.

A plastic material for a composite of the second invention may be made of either a thermosetting resin or a thermoplastic resin like a composite of the first invention.

In a composite of the second invention, the aspect ratio and average particle diameter of ceramic particles are the same as those of the first invention.

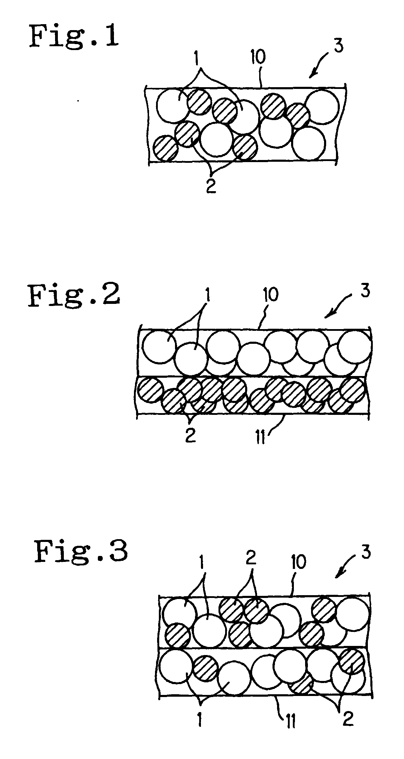

As shown in Fig. 1, a plastic-ceramic compound of the second invention has a structure having a single layer. The single layer 10 may contain at least two different ceramic particles 1 and 2. Alternatively, as shown in Fig. 2, a plastic-ceramic compound of the second invention may have a layered structure, in which ceramic particles 1 and 2 having different properties are dispersed in each of the layers 10 and 11, respectively.

As shown in Fig. 3, each of the layers 10 and 11 may contain both ceramic particles 1 and 2 having different properties in a different compounding ratio.

Next, the third invention is described. When a portion of the constitution in the third invention is the same as those of the first and second inventions, its description has been omitted.

In a plastic-ceramic composite of the third invention, ceramic particles are dispersed in a plastic matrix. Plastic used for the plastic matrix has at least one property selected from a group consisting of dielectricity, piezoelectricity and magnetism. Ceramic used for the ceramic particles has at least one property selected from a group consisting of dielectricity, piezoelectricity, magnetism, conductivity and heat conductivity. The content of ceramic particles is 30 vol% or more and 99 vol% or less.

Since a plastic-ceramic component of the third invention has both a property derived from the ceramic material and a property derived from the plastic material, a plurality of members each with its own characteristics can be replaced by a single member composite of the third invention. Therefore, a plastic-ceramic component of the third invention contributes to improvements in productivity, cost reductions, decreases in the number of members and the like. Additionally, a completely new use is found. For example, in a high-speed high displacement actuator or the like, if plastic having piezoelectricity and ceramic having high heat conductivity are used together, heat generated due to vibrations of the piezoelectric body can be radiated and the temperature related property changes can be decreased.

Since a plastic-ceramic composite of the third invention is formed by dispersing ceramic particles in plastic, it can be easily produced by injection molding or the like, at a low cost. Therefore, a reaction between different ceramics during firing does not occur, and the properties of each kind of ceramic are not lost, and both a property of plastic and a property of ceramic can be imparted to the composite. This means that, when at least two kinds of ceramic having different properties are used for ceramic particles in a composite of the third invention, properties derived from at least two different ceramics can be imparted to the composite without loosing properties of each ceramic during firing. This further means that, when at least two kinds of ceramics having different characteristic values and the same property are used, characteristic values of a composite derived from the ceramics can be controlled by changing the compounding ratio.

In composite of the third invention, a characteristic values derived from plastic or ceramic can be independently controlled by changing the compounding ratio of the plastic and the ceramic. When ceramic and plastic having different characteristic values and the same properties are used, a characteristic value of the composite can be controlled by changing the compounding ratio.

For example, regarding dielectricity, an intermediate dielectric constant can be obtained in accordance with a compounding ratio because of additivity in mixing ceramic particles and plastic particles having different dielectric constants. Regarding piezoelectricity, piezoelectricity can be controlled by mixing a ceramic and a plastic having different piezoelectric constants.

When a mixture of two kinds of plastic materials having different properties is used for a composite of the third invention, characteristic values derived from the plastics can be individually controlled by changing the compounding ratio of the two kinds of plastic materials. When at least two kinds of plastics having different characteristic values and the same properties, are used characteristic values of a composite can be controlled in the same manner.

In a composite of the third invention, the content of ceramic particles is 30 vol% or more, which is different from the content of ceramic particles of 50 vol% or more of the first and second inventions.

A dielectric plastic material used for a composite of the third invention is not limited because all plastics have dielectricity.

As a piezoelectric plastic, there can be used poly(vinylidene fluoride) (PVDF) or the like.

As a magnetic plastic, there can be used poly(2,6-pyridinediylmethylidenenitrohexamethylenenitromethylidene) (PPH), decamethylferrocenium, 7,7,8,8-tetracyano-p-quinodimethanid, decamehyl ferroceniumtetracyanoethylenide, or the like.

Plastic used for a composite of the third invention may be either a thermosetting resin and a thermoplastic resin as composites of the first and the second inventions. However, a thermoplastic resin is preferably used.

An aspect ratio and an average particle diameter of a composite of the third invention are the same as those of the first and the second invention.

Incidentally, in plastic-ceramic composites of the first, second and third inventions, ceramic particles are preferably connected with a plastic matrix by silane coupling.

Silane coupling enables the use of a ceramic having low compatibility and an increase in the content of the ceramic.

A composite of plastic-ceramic of the present invention is produced by, for example, the following method.

### (Preparation of ceramic particles)

A plurality of powders having a predetermined aspect ratio and an average particle diameter are mixed together so as to prepare ceramic particles having a desired average particle diameter and aspect ratio. When a composite consisting of a layer of the second invention is produced, ceramic particles having different properties are mixed together in a desired ratio. When a layered composite is produced, ceramic particles are prepared by each individual layer. Regarding distribution of particle size of the ceramic particles, it is preferable that at least 90% of the ceramic particles have particle diameters of 1 - 100 µm. The distribution of particle size is adjusted by mixing powders each having a predetermined distribution of particle size in the aforementioned manner.

When the aspect ratio of a powder is too high, secondary particles obtained by granulation can be used by controlling an aspect ratio of the secondary particles to be 2.0 or less. Granulation can be conducted by a spray dryer, or the like. An aspect ratio of the secondary particles is preferably 2.0 or less. This is because the ceramic particles can be treated in the same manner as the primary particles with regard to the amount used when mixing the ceramic particles with the plastic and the method used if the secondary particles have the aforementioned aspect ratio.

Then, as necessary, ceramic particles are subjected to silane coupling. The silane coupling is conducted by a known method such as an integral blending and a pretreatment by a spray or the like.

### (Mixing of ceramic particles and plastic particles)

First, ceramic particles are mixed with plastic particles. The plastic particles are molten at a temperature a little higher than the melting point of the plastic particles to obtain a plastic matrix, and the ceramic particles are then dispersed in the plastic matrix. The aforementioned mixing and dispersion treatments are conducted by the use of a kneader, a trirolling mill and the like.

Then, the kneaded mixture is pelletized.

The plastic components in the pellet are molten at a temperature a little higher than the melting point of the plastic components, and the mixture is subjected to molding by a known molding method such as extrusion molding, injection molding or the like. In consideration of productivity and reduction of production costs, injection molding is preferable. A plurality of sheets each having a thickness of about 10 - 1000 µm can constitute a layered compact having an arbitrary thickness. The sheets are connected by, for example, press heating.

The present invention is described in more detail with reference to the Examples. However, the present invention is by no means limited to these Examples.

### ( Example 1: First invention )

There were used polystyrene (specific dielectric constant of 2.5) as a plastic material and titanium oxide (specific dielectric constant of 100) as a ceramic material so as to give a plastic-ceramic composite a content of ceramic particles of 75 vol%. Incidentally, the ceramic particles had an average particle diameter of 30 µm and an aspect ratio of 1.20.

First, the ceramic particles were subjected to silane coupling by a spray method. Then, the ceramic particles were mixed with plastic particles at 280°C by a kneader to obtain a mixture. The mixture was then pelletized. The pellet was molten at 270°C and subjected to injection molding to obtain a laminar composite of 50 mm x 50 mm x 5 mm. Table 1 shows the dielectricity of the composite.

### ( Example 2: First invention )

There were used polycarbonate (specific dielectric constant of 3) as a plastic material and strontium titanate (specific dielectric constant of 250) and PZT (specific dielectric constant of 800) as ceramic materials, resulting in a plastic-ceramic composite having a total content of ceramic particles of 80 vol% (content of strontium titanate: 40 vol%, and content of PZT: 40 vol%). A plastic-ceramic composite was produced in the same manner as in Example 1 except that the ceramic particles were mixed with plastic particles at 330°C, the pellet was molten at 320°C and the ceramic particles had an average particle diameter of 20 µm and an aspect ratio of 1.45. Table 1 shows the dielectricity of the obtained composite.

### ( Example 3: First invention )

There were used polyamideimide as a plastic material and PZT-1 and PZT-2 as ceramic materials, resulting in a plastic-ceramic composite having a total content of ceramic particles of 90 vol% (content of PZT-1: 1.35 vol%, and content of PZT-2: 55 vol%). A plastic-ceramic composite was produced in the same manner as in Example 1 except that the ceramic particles were mixed with plastic particles at 370°C, the pellet was molten at 370°C, PTZ-1 had an average particle diameter of 25 µm and an aspect ratio of 1.25 and PTZ-2 had an average particle diameter of 30 µm and an aspect ratio of 1.35. Table 1 shows the dielectricity of the obtained composite. PTZ-1 had a frequency temperature coefficient of +10 ppm/°C, and PTZ-2 had a frequency temperature coefficient of -6ppm/°C. Table 1 shows a frequency temperature coefficient of the obtained composite.

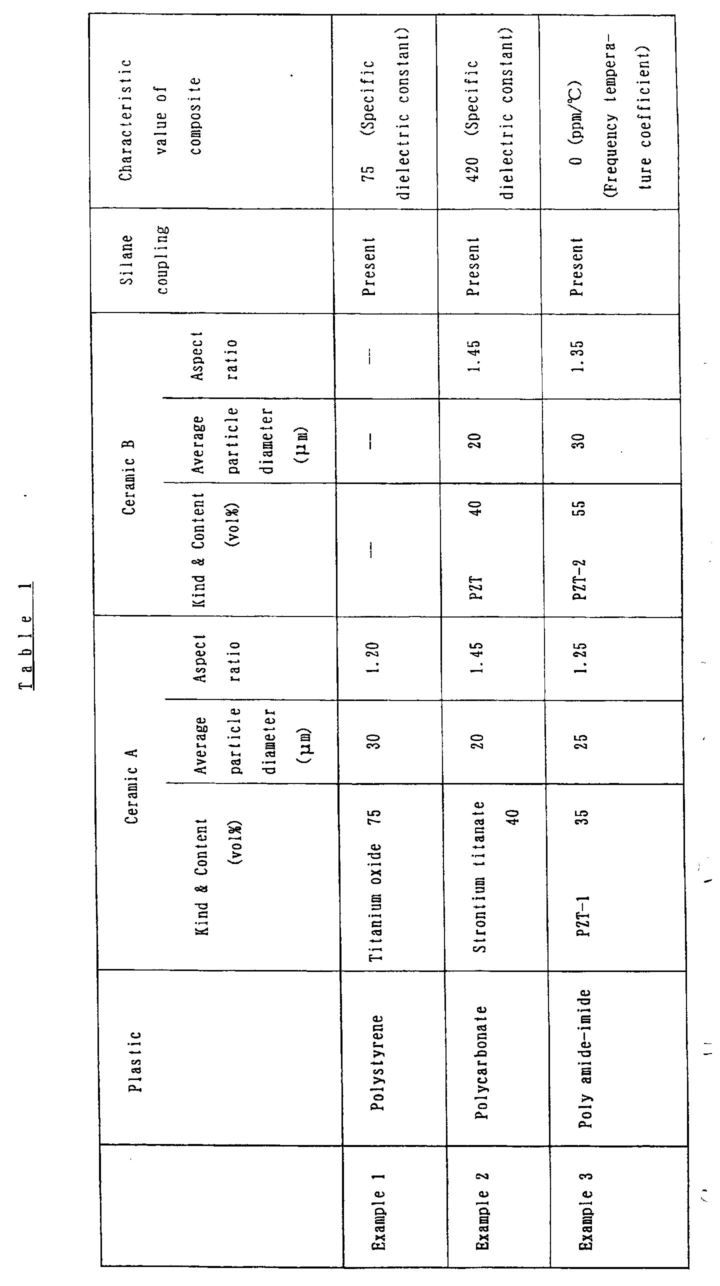

### ( Example 4: Second invention )

There were used vinyl chloride as a plastic material and lead zirconate titanate (PZT) having piezoelectricity and Ni-Cu-Zn ferrite having magnetism as ceramic materials so as to obtain a plastic-ceramic composite of a single layer having a content of ceramic particles of 85 vol%. The PZT particles and Ni-Cu-Zn ferrite particles had average particle diameters of 10 µm and 25 µm, respectively, and aspect ratios of 1.5 and 1.2, respectively. A compounding ratio of PZT particles : Ni-Cu-Zn ferrite was 60 : 40.

A mixture having the aforementioned compounding ratio of the ceramic powders was subjected to silane coupling by a spray method. Then, the ceramic particles were mixed with plastic particles at 170°C to obtain a mixture. The mixture was pelletized, and the resulting pellets were molten at 170°C and subjected to injection molding to obtain a laminar composite of 50 mm x 50 mm x 5 mm. Table 2 shows a piezoelectric constant and a specific permeability of the obtained composite. Incidentally, PZT had a piezoelectric constant D₃₃ of 220, and Ni-Cu-Zn ferrite had a specific permeability of 800.

### ( Example 5: Second invention )

There were used polyacrylate as a plastic material and strontium titanate (specific dielectric constant of 250) and Mn-Zn ferrite having magnetism (specific dielectric constant of 160) as ceramic materials. The ceramic materials were separately mixed with polyacrylate in different layers to produce a plastic-ceramic composite having two layers, each of which had a content of ceramic particles of 90 vol%. Incidentally, the strontium titanate ceramic particles and Mn-Zn ferrite ceramic particles had average particle diameters of 15 µm and 25 µm, respectively, and aspect ratios of 1.6 and 1.3, respectively.

A pellet was prepared for each of the layers constituting the composite in the same manner as in Example 4. The mixing and separation were performed at 260°C. Then, the pellet for each of the layers was molded by extrusion molding to give a sheet having a thickness of 1 mm. The sheets were connected with each other by press heating so as to obtain a layered composite. Table 2 shows a specific dielectric constant and a specific permeability of the obtained composite. Incidentally, the characteristic values are the same as those measured independently before the layers are connected.

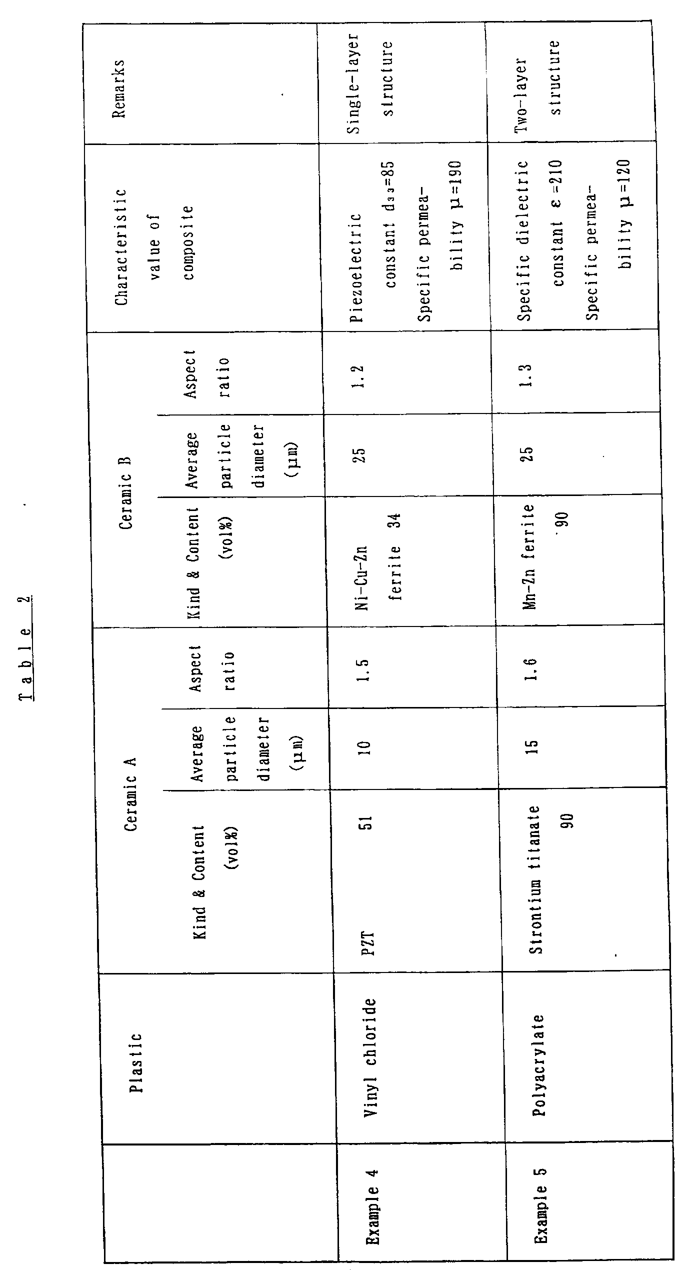

### ( Example 6: Third invention )

There were used PVDF having piezoelectricity as a plastic material and Mn-Zn ferrite having magnetism in order to obtain a plastic-ceramic composite having a content of ceramic particles of 50 vol%. Incidentally, the ceramic particles had an average particle diameter of 30 µm and an aspect ratio of 1.20.

First, the ceramic particles were subjected to silane coupling by a spray method. Then, the ceramic particles were mixed with plastic particles and dispersed in the plastic particles at 270°C by the use of a kneader to obtain a mixture. The mixture was then pelletized. The obtained pellets were molten at 250°C and subjected to injection molding to obtain a laminar composite of 50 mm x 50 mm x 5 mm. Table 3 shows a piezoelectric constant and a specific permeability of the obtained composite.

### ( Example 7: Third Invention )

There were used PVDF having piezoelectricity as a plastic material and aluminum nitride having heat conductivity to obtain a plastic-ceramic composite having a content of ceramic particles of 50 vol% in the same manner as in Example 6. Incidentally, the ceramic particles had an average particle diameter of 20 µm and an aspect ratio of 1.45. Table 3 shows a piezoelectric constant and a heat conductivity of the obtained composite.

### ( Example 8: Third Invention )

There were used polycarbonate having dielectricity as a plastic material and aluminum nitride having heat conductivity so as to obtain a plastic-ceramic composite having a content of ceramic particles of 60 vol% in the same manner as in Example 6. Incidentally, injection molding was conducted at 300°C. The ceramic particles had an average particle diameter of 20 µm and an aspect ratio of 1.45. Table 3 shows specific dielectric constant and heat conductivity of the obtained composite.

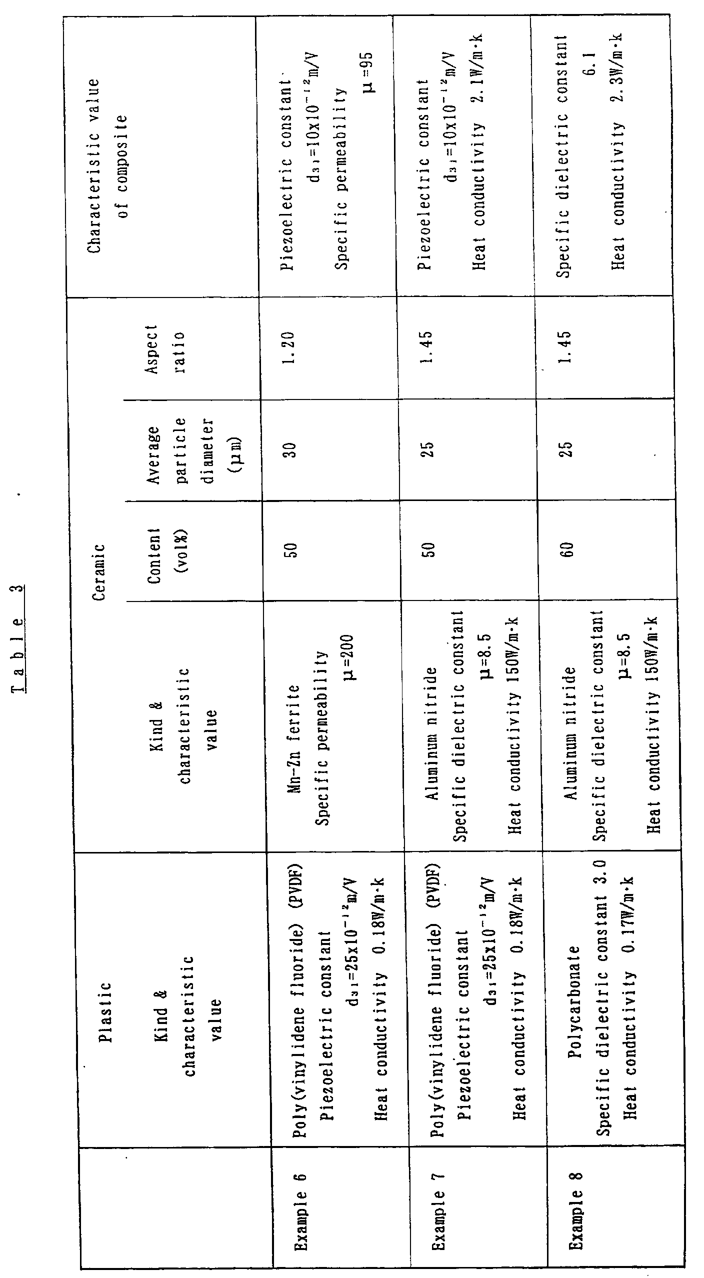

### Industrial Applicability

As described above, a composite of the first invention can be suitably used for parts in which a ceramic dielectric body has conventionally been used, such as an IC package, a condenser and an LC filter, parts in which a piezoelectric body has conventionally been used, such as vibrating gyroscopes, oscillators and sensors, parts in which magnetic body has conventionally been used, such as the magnetic core of a transducer, coil or the like, a motor, and parts in which a ceramic heat conductive body has been used, such as package for power electronics parts such as thyristor.

Additionally, a composite of the first invention can be an electromagnetic wave absorber or an electromagnetic wave reflector through the use of ceramic particles having magnetism or conductivity.

Further, according to composites of the second and the third inventions, for example, electronic parts in which a coil using a magnetic core and a ceramic capacitance are separately used can be unified. Additionally, the composites of the second and the third inventions provide new uses, for example, an actuator which combines piezoelectricity and heat conductivity driven with diffusing heat generated by vibrations, combining piezoelecricity and magnetism to create an interior wall material which is able to insulate sound by piezoelectricity and to absorb and intercept electromagnetic waves by magnetism, or a toy which is driven by an supersonic wave motor method and does not separate from the metal.

## Claims

1. A plastic-ceramic composite comprising:
a plastic matrix, and
ceramic particles dispersed in said plastic matrix;
wherein said ceramic has a property selected from a group consisting of dielectricity, piezoelectricity, magnetism, conductivity, and heat conductivity, and the content of said ceramic particles is 50 vol% or more and 99 vol% or less.

2. A plastic-ceramic composite according to claim 1, wherein said ceramic particles comprise at least two kinds of ceramics having different characteristic values and the same property.

3. A plastic-ceramic composite comprising:
a plastic matrix, and
ceramic particles dispersed in said plastic matrix;
wherein, as said ceramic, at least two different ceramics corresponding with at least two properties selected from a group consisting of dielectricity, piezoelectricity, magnetism, conductivity and heat conductivity are employed; and the content of said ceramic particles is 50 vol% or more and 99 vol% or less.

4. A plastic-ceramic composite according to claim 3, wherein said plastic-ceramic composite has a laminated structure having layers, each of which contains ceramic different from that of the other layer(s).

5. A plastic-ceramic composite according to claim 3, wherein each of said layers contains at least two kinds of ceramics corresponding with said at least two properties in the compounding ratio different from that of the other layer(s).

6. A plastic-ceramic composite according to claim 3, wherein the plastic-ceramic composite comprises a layer containing at least two ceramics corresponding with said at least two properties.

7. A plastic-ceramic composite comprising:
a plastic matrix, and
ceramic particles dispersed in said plastic matrix;
wherein said plastic has at least one property selected from a group consisting of dielectricity, piezoelectricity and magnetism; said ceramic has at least one property selected from a group consisting of dielectricity, piezoelectricity, magnetism, conductivity and heat conductivity; and the content of said ceramic particles is 30 vol% or more and 99 vol% or less.

8. A plastic-ceramic composite according to any one of claims 1 - 7, wherein each of said ceramic particles has an aspect ratio of 2.0 or less.

9. A plastic-ceramic composite according to any one of claims 1 - 8, wherein said ceramic particles are combined with a plastic matrix by silane-coupling.

10. An article obtained by subjecting said plastic-ceramic composite according to any one of claims 1 - 9, to injection molding.

11. An article obtained by molding said plastic-ceramic composite, according to any one of claims 1 - 9, into the shape of a sheet.
